# EUROPEAN PATENT APPLICATION

(11) **EP 4 621 820 A1**
(43) Date of publication of application: **24.09.2025**
(21) Application number: 24305426.9
(22) Date of filing: 21.03.2024
(51) Int. Cl.: H01G 4/33, H01G 4/012, H01G 4/10, H01G 4/38, H01G 4/40, G01R 3/00, G01R 27/00, H01L 21/3213, H01L 23/522, H01L 27/08, H01L 21/02, H01L 29/66, H01L 29/94, H01G 4/005, G01R 1/20

(54) **AN ELECTRICAL DEVICE FOR MEASURING AN ELECTRICAL PARAMETER OF A CONDUCTIVE LAYER TO BE CHARACTERIZED INCLUDING MULTIPLE 2D CAPACITORS**

(71) Applicant: Murata Manufacturing Co., Ltd., Nagaokakyo-shi, Kyoto 617-8555 (JP)
(72) Inventor: JACQUELINE, Sébastien, 14000 CAEN (FR); AUBRY, Yves, 14000 CAEN (FR); VOIRON, Frédéric, 38530 BARRAUX (FR)
(74) Representative: Cabinet Beau de Loménie

(57) **Abstract**

An electrical device for measuring an electrical parameter of a conductive layer to be characterized, comprising:
a substrate (300),
a conductive anodization barrier (303),
a vertically conductive region (304, REG),
an anodic porous oxide region (306),
a bottom capacitor electrode layer including a 3D portion (308A) extending inside the pores of the portion anodic porous oxide region through the opening, and at least two 2D portions (308B_A, 308B_B),
a dielectric layer including at least two 2D portions (309B_A, 309B_B) above the at least two 2D portions of the first capacitor electrode layer, and a 3D portion (309A),
a top capacitor electrode layer including at least two 2D portions (310B_A, 310B_B) above the at least two 2D portions of the dielectric layer, and a 3D portion (310A),
the bottom capacitor electrode being said conductive layer to be characterized.

## Description

### Field of the Invention

The present invention relates to the field of integration and, more particularly, to electrical devices, related semiconductor products, and their methods of manufacture.

### Technical Background

Silicon passive integration technologies are nowadays accessible for industrial design. For example, the PICS technology developed by Murata Integrated Passive Solutions allows integrating high density capacitive components into a silicon substrate. According to this technology, thousands of passive components can be efficiently integrated into a silicon wafer.

In particular, it has been proposed to form three-dimensional (3D) conductive silicon structures by using Reactive Ion Etching, followed by subsequent deposition steps of a dielectric and of a conductive material to form capacitors. The increase in terms of capacitance density results from the capacitors having a 3D shape. These capacitors are known as 3D capacitors. Document WO 2007/125510 discloses a method for forming such 3D capacitors.

In their work titled "Nanotubular metal-insulator-metal capacitor arrays for energy storage" (published in Natural technology, May 2009), P. Banerjee et al. describe a metal-insulator-metal (MIM) structure formed in a porous anodic material, such as porous anodic alumina (PAA) for example. The successive layers of metal, insulator, and then metal follow the contours of the porous material resulting in the MIM structure being embedded inside the pores of the porous material. Banerjee's PAA embedded structure however suffers from high Equivalent Series Resistance (ESR) and limited capacitance density due to the PAA thickness that can be deposited by Atomic Layer Deposition (ALD).

A structure by F. Voiron et al. that improves Banerjee's ESR and capacitance is described in international application publication WO 2015/063420 A1. Voiron's structure results in highly integrated capacitance that may be used in a variety of applications. In this structure the bottoms of the pores are opened and the lower metal layer of the MIM structure contacts a conductive layer that underlies the porous region, providing electrical contact and reducing ESR.

It is desirable to characterize the bottom electrode of such capacitors, for example to obtain a measurement of the sheet resistance of the material deposited to form the bottom electrode. It should be noted that the bottom electrode is the main contributor to the capacitor ESR, and therefore it is critical to control. It is also desirable for some applications to have a resistor in series with a capacitor.

Figure 1 shows how, in 3D capacitors formed using the method of document WO 2015/063420 A1, contact openings are manufactured to access electrodes. Above a silicon substrate 200 having a silicon dioxide layer 201 on top of it (formed by oxidation or alternatively by deposition), a plurality of conductive layers are successively formed: an aluminum layer 202 (by physical vapor deposition), a tungsten layer 203 (by physical vapor deposition), and another thick aluminum layer 204 (by physical vapor deposition).

In order to delimit the portion of the aluminum layer 204 to be anodized, a first hard mask 205 is formed above aluminum layer 204, with an opening. Anodization is then carried out to obtain an anodic porous oxide region 206 comprising straight pores (vertical on the figure) that extend from the top face of the anodic porous region to the tungsten layer 203. In fact, the tungsten layer 203 acts as an anodization barrier.

In a manner which is similar to what has been described in prior art document WO 2019/215284, another hard mask 207 is formed above the structure to delimit the vertical pores that are intended to be used subsequently to form a capacitor. Hard mask 207 therefore comprises an opening that delimits an anodic porous oxide region.

Above the structure and inside the pores, a stack of materials is formed in a conformal manner including:
- A bottom capacitor electrode layer 208 (titanium nitride: TiN),
- A dielectric layer 209 (Oxide-Nitride-Oxide: ONO),
- A top capacitor electrode layer 210 (titanium nitride: TiN)

A 3D capacitor is formed. Subsequently, a conductive layer 211 is formed above the top capacitor electrode layer 210 to facilitate forming a metal contact. A photolithography step is then carried out to delimit this layer. During the etching of this photolithography, the portions of the top capacitor electrode layer 210 not intended to be covered by the conductive layer 211 are etched away as well.

An opening is then formed on the right of the anodic porous oxide region through the dielectric layer 209 and the bottom capacitor electrode layer 208, so as to reach the aluminum layer 204 (through this opening, it is possible to electrically contact the bottom capacitor electrode 208 through the aluminum layer 204). Forming this opening can be performed by means of a photolithography step using a specific mask configured to delimit the opening and an etching through the hard mask 205, the hard mask 207, the bottom capacitor electrode layer 208 and the dielectric layer 209.

Subsequently, an insulator layer 212 is deposited and patterned to delimit two contact openings, one for the top capacitor electrode through conductive layer 211, and one for the bottom capacitor electrode through the opening formed on the right of the figure. More precisely, the bottom electrode is electrically accessed through the aluminum layer 204, and the tungsten layer 203, which contacts the bottom capacitor layer 208 at the bottom of the pores where this layer is deposited.

The above implementation is not suitable to form one or several electrical contacts to the bottom electrode 208.

In fact, making such an electrode accessible would require etching through the dielectric layer and stopping at the level of the electrode, which can be particularly difficult to obtain. The layers that form the 3D capacitors are particularly thin (typically of the order of 10 nanometer), making stopping on the bottom layer difficult. This prevents characterizing the bottom electrode layer and in particular measuring its sheet resistance.

Thus, there exists a need for a solution to characterize this layer.

The present invention has been made in the light of the above problems.

### Summary of the Invention

The present invention provides an electrical device for measuring an electrical parameter of a conductive layer to be characterized, comprising:
a substrate,
a conductive anodization barrier above the substrate,
a vertically conductive region above the conductive anodization barrier (for example, the vertically conductive region is electrically conductive from the top to the bottom of the region, and it is for example a metal region or an anodic porous oxide region comprising vertical straight pores that extend from the top to the bottom of the region, these pores comprising a conductive material extending from the top to the bottom of the region),
an anodic porous oxide region above the substrate, comprising straight pores extending from a top face of the anodic porous oxide region to the conductive oxidation barrier (the pores are substantially perpendicular to this top face and the conductive anodization barrier), the anodic porous oxide region being adjacent to the vertically conductive region (by adjacent, what is meant is adjacent laterally, not above or under),
an insulating region above the vertically conductive region and the anodic porous oxide, having an opening delimiting a portion of the anodic porous oxide region,
a bottom capacitor electrode layer including a 3D (three-dimensional) portion extending inside the pores of the portion anodic porous oxide region through the opening (for example, the 3D portion is conformal and conforms to the shape of the pores - for example the 3D portion is in electrical contact with the conductive anodization barrier - for example, by 3D, what is meant is that the 3D portion comprises surfaces extending in the three orthogonal dimensions), and at least two 2D (two-dimensional) portions extending above the insulating region, the bottom capacitor electrode layer extending between the at least two 2D portions of the bottom capacitor electrode layer, the 2D portions and the 3D portion of the bottom capacitor electrode layer being in electrical contact (i.e. they form, together, a contiguous layer, for example the same layer deposited in a single deposition step, for example a patterned layer),
a dielectric layer (for example a single layer, deposited conformally) including at least two 2D portions above the at least two 2D portions of the first capacitor electrode layer (for example, by 2D, what is meant is that the 2D portion comprises surfaces that only extend in two dimensions (a plane)), and a 3D portion above the 3D portion of the bottom capacitor electrode layer and inside the pores of the portion of the anodic porous oxide region,
a top capacitor electrode layer (for example a single layer, deposited conformally) including at least two 2D portions above the at least two 2D portions of the dielectric layer, and a 3D portion above the 3D portion of the dielectric layer and inside the pores of the portion, so that at least two 2D capacitors are formed by the at least two 2D portions of the bottom capacitor electrode layer, the at least two 2D portions of the dielectric layer, and the at least two 2D portions of the top capacitor electrode layer, and so that a 3D capacitor is formed by the 3D portion of the bottom capacitor electrode, the 3D portion of the dielectric layer, and the 3D portion of the top capacitor electrode layer,
the bottom capacitor electrode being said conductive layer to be characterized.

The layer to be characterized can be characterized through at least the two 2D portions of the top capacitor electrode.

Thus, the above device proposes to form an access to a planar portion of the bottom capacitor electrode layer through at least two 2D capacitors formed alongside a 3D capacitor.

Measurements can be made through the at least two 2D portions of the top capacitor electrode layer, for example to measure a resistance/resistivity (as electrical parameter, the person skilled in the art being able to consider the impact of the presence of the 2D capacitances when measuring a resistance/resistivity).

Thus, information concerning the bottom capacitor electrode layer can be obtained without having to etch through the top capacitor electrode layer and the dielectric layer to reach the bottom capacitor electrode layer.

Also, delimiting the 2D portions and the 3D portion of the top capacitor electrode layer can be performed in the photolithography step used to delimit a conductive layer deposited to form this electrode.

It should be noted that the device comprises both a 3D capacitor and a 2D resistor in series with the 3D capacitor, this 2D resistor extending between the at least two 2D capacitors.

According to a particular embodiment, the device comprises a bottom capacitor electrode layer including a 3D portion extending inside the pores of the portion anodic porous oxide region (here the 3D portion mentioned above), four 2D portions extending above the insulating region (including the two 2D portions mentioned above), the bottom capacitor electrode layer extending between the four 2D portions of the bottom capacitor electrode layer (for example, there is a continuous portion of the layer that electrically connects the four 2D portions of the bottom capacitor electrode layers), the 2D portions and the 3D portion of the bottom capacitor electrode layer being in electrical contact,
a dielectric layer including four 2D portions (including the two 2D portions mentioned above) above the four 2D portions of the first capacitor electrode layer, and a 3D portion (mentioned above) above the 3D portion of the bottom capacitor electrode layer and inside the pores of the portion of the anodic porous oxide region,
a top capacitor electrode layer including four 2D portions (including the two 2D portions mentioned above) above the four 2D portions of the dielectric layer, and a 3D portion (mentioned above) above the 3D portion of the dielectric layer and inside the pores of the portion, so that four capacitors (including the two already mentioned) are formed by the four 2D portions of the bottom capacitor electrode layer, the four 2D portions of the dielectric layer, and the four 2D portions of the top capacitor electrode layer.

It appears that using four capacitors allows further characterizing to be performed. The bottom capacitor electrode layer extending between the four 2D portions of the bottom capacitor electrode layer can delimit a zone of bottom capacitor electrode layer that will be characterized through the four 2D portions of the top capacitor electrode layer, for example to measure the sheet resistance (as electrical parameter).

According to a particular embodiment, the bottom capacitor electrode layer is continuous in a region containing the four 2D portions of the bottom capacitor electrode layer.

By continuous, what is meant here is that the bottom capacitor electrode layer interconnects the four 2D portions of the bottom capacitor electrode layer in an uninterrupted manner, i.e. there is a current path between each 2D portion of the capacitor electrode layer that is within the bottom capacitor electrode layer and this path is within a zone that contains the four 2D portions of the bottom capacitor electrode layer.

According to a particular embodiment, the bottom capacitor electrode layer is patterned into a given shape, wherein the four 2D portions of the bottom capacitor electrode layer are each arranged evenly around the given shape so as to be arranged in a Van der Pauw pattern, the given shape having two mutually orthogonal axes of symmetry such as a square or a cross or a circle (the shape being observable from the top, the axes of symmetry being also observable from the top).

By arranged evenly, what is meant is that the 2D portions are either directly connected to a respective side or connected to the side by a path of bottom capacitor electrode layer, or for example connected to a respective corner.

The person skilled in the art will be able to place the 2D portions at appropriate positions to be able to implement Van der Pauw's method, for example to measure the sheet resistance of the bottom electrode layer. In particular, what is meant by "in a Van der Pauw pattern" is that the 2D portions will be evenly distributed around the square (for example each in the middle of a side, or connected to a middle of a side, or even connected to a respective corner) to allow performing the Van der Pauw's method. This method is described in document "A method of measuring the resistivity and Hall coefficient on lamellae of arbitrary shape" (1958, Philips Technical Review. 20: 220-224).

According to a particular embodiment (which is an alternative to the embodiment in which the bottom electrode is patterned), the bottom capacitor electrode layer extends further than the four 2D portions of the bottom capacitor electrode layer.

For example, the four 2D portions can be distributed in a square arrangement, and the bottom capacitor electrode layer can completely overlap a region that comprises the four 2D portions. Here and in this alternative embodiment, the bottom capacitor electrode is not patterned, in particular between the four 2D portions of the capacitor electrode layer.

According to a particular embodiment, the 2D portions of the dielectric layer are damaged and conducting at the level of each 2D capacitor.

By damaged, what is meant is that the 2D capacitors have undergone a voltage breakdown such that the 2D portions of the dielectric layer become permanently more electrically conductive than its original non-damaged state.

The person skilled in the art will be able to determine whether a dielectric layer has been damaged.

This allows performing direct characterizing of the bottom capacitor electrode layer without having to take into account the capacitances of the 2D capacitors.

The person skilled in the art will be able to determine the voltage to be applied to damage the dielectric layer, in particular in accordance with the thickness of the dielectric layer.

Also, when the dielectric layer is damaged, this facilitates using the device as a series-connected 2D resistor and 3D capacitor, the 2D resistor being accessed by one of the 2D capacitors having its dielectric damaged.

It should be noted that the van der paw measurement technique separates the current injection path (force) and the voltage probing path (sense) such that the resistance of both paths does not affect the measurement. This implies that should resistances remain through the damaged dielectrics that may not be controllable, this will not affect the end measurement.

According to a particular embodiment, a 2D bottom contact is arranged above the vertically conductive region, the 2D bottom contact being in electrical contact with at least one 2D portion of the bottom capacitor electrode layer of a 2D capacitor through the vertically conductive region and the 3D portion of the bottom capacitor electrode layer.

The 2D bottom contact can comprise a conductive region arranged in an opening of another insulating region which is usually called a contact opening.

This 2D bottom contact can facilitate damaging the 2D dielectrics. In particular, it allows not having to pass current through another 2D capacitor during this damaging.

The invention also provides a method of manufacturing an electrical device for measuring an electrical parameter of a conductive layer to be characterized, the method comprising:
providing a substrate,
forming a conductive anodization barrier above the substrate,
depositing a metal layer above the substrate,
anodizing a region of the metal layer to obtain (the region of the metal layer can include a portion or the entire metal layer):
   an anodic porous oxide region above the substrate, comprising straight pores extending from a top face of the anodic porous oxide region to the conductive anodization barrier,
   a vertically conductive region above the substrate, the anodic porous oxide region being adjacent to the vertically conductive region,
   forming a bottom capacitor electrode layer including a 3D portion extending inside the pores of the portion anodic porous oxide region and at least two 2D portions extending above the insulating region, the bottom capacitor electrode layer extending between the at least two 2D portions of the bottom capacitor electrode layer, the 2D portion and the 3D portion of the bottom capacitor electrode layer being in electrical contact,
   forming a dielectric layer including at least two 2D portions above the at least two 2D portions of the first capacitor electrode layer, and a 3D portion above the 3D portion of the bottom capacitor electrode layer and inside the pores of the portion of the anodic porous oxide region,
   forming a top capacitor electrode layer including at least two 2D portions above the at least two 2D portions of the dielectric layer, and a 3D portion above the 3D portion of the dielectric layer and inside the pores of the portion, so that at least two capacitors are formed by the at least two 2D portions of the bottom capacitor electrode layer, the at least two 2D portions of the dielectric layer, and the at least two 2D portions of the top capacitor electrode layer, and so that a 3D capacitor is formed by the 3D portion of the bottom capacitor electrode, the 3D portion of the dielectric layer, and the 3D portion of the top capacitor electrode layer,
   the bottom capacitor electrode being said conductive layer to be characterized.

This method can be adapted for the manufacture of any one of the embodiments of the above defined device.

According to a particular embodiment, the method comprises applying a voltage between each 2D portion of the top capacitor electrode layer and another point in the device (for example another 2D portion of the top capacitor electrode or the 2D bottom contact) so as to damage the 2D portions of the dielectric layer below each 2D portion of the top capacitor electrode layer so as to make it conducting at the level of each 2D capacitor.

The invention also provides a method of characterizing an electrical device, comprising obtaining an electrical device as defined above, and measuring an electrical parameter of the bottom capacitor electrode layer through the 2D portions of the top electrode layer of the at least two 2D capacitors.

According to a particular embodiment the electrical device is an electrical device wherein the 2D portions of the dielectric layer are damaged and conducting at the level of each 2D capacitor, the method comprising measuring the electrical resistivity between two top electrodes of the at least two 2D capacitors.

According to a particular embodiment, the electrical device is an electrical device wherein the 2D portions of the dielectric layer are damaged and conducting at the level of each 2D capacitor, and wherein the device is a device having four 2D capacitors as defined above,
comprising measuring the sheet resistance of the bottom capacitor electrode layer through the four 2D portions of the top capacitor electrode layer.

According to a particular embodiment, the sheet resistance is measured using Van der Pauw's method.

Here, characterizing the bottom capacitor electrode layer comprises obtaining its sheet resistance.

### Brief Description of the Drawings

Further features and advantages of the present invention will become apparent from the following description of certain embodiments thereof, given by way of illustration only, not limitation, with reference to the accompanying drawings in which:

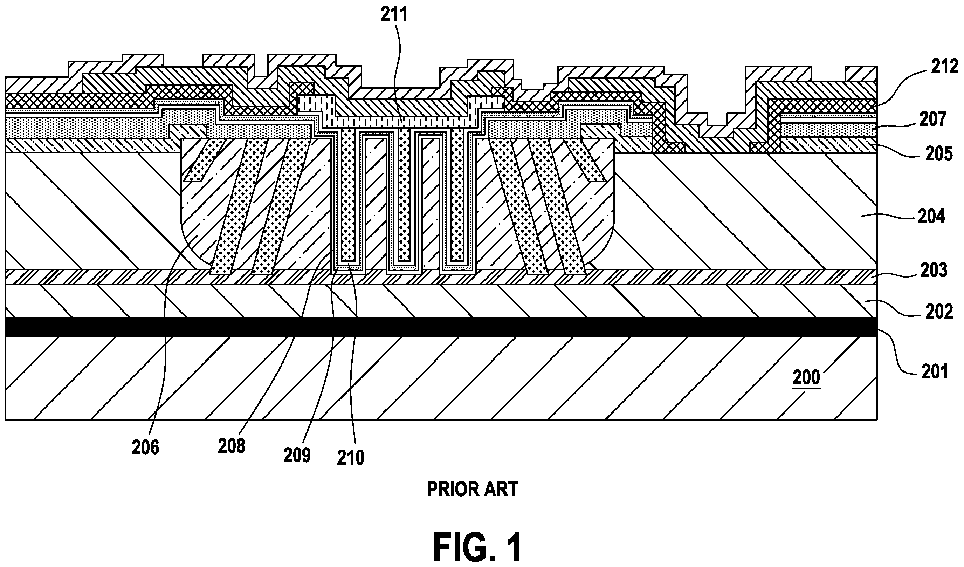

- Figure 1, already described, shows a device according to the prior art,
- Figure 2 is a side view of a device according to an example,
- Figure 3 is a top view of a device according to an example.

### Detailed Description of Example Embodiments

We will now describe an electrical device including 2D (two dimensional) capacitors and a 3D (three dimensional) capacitor manufactured simultaneously that facilitates characterizing the bottom capacitor electrode layer of these capacitors.

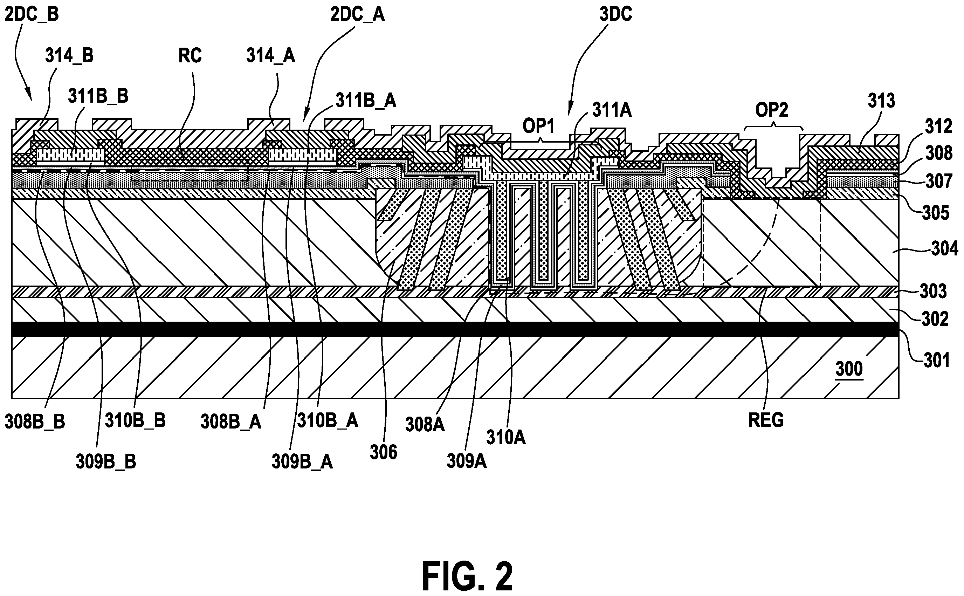

Figure 2 is a cross section of an electrical device according to an example.

Here, a silicon substrate 300 is used to support the structure. Other materials may be used. A silicon dioxide layer 301 has been grown on the top face of silicon substrate 300 by oxidation.

Subsequently, a first aluminum layer 302 is formed (here by physical vapor deposition), and, on top of it, a tungsten layer 303 (by physical vapor deposition). The tungsten layer will act as a conductive anodization barrier above the substrate, for a subsequent anodization step.

A thick aluminum layer 304 is formed (by physical vapor deposition) on the tungsten layer. This thick aluminum layer may have a thickness of a few micrometers, for example between 3 and 15 micrometers, typically 7 micrometers.

In order to delimit the portion of the aluminum layer 304 to be anodized, a first hard mask 305 (for example insulating) is formed above aluminum layer 304, with an opening. Anodization is then carried out to obtain an anodic porous oxide region 306 comprising straight pores (vertical on the figure) that extend from the top face of the anodic porous region to the tungsten layer 303 (as the tungsten layer acts as an anodization barrier).

It should be noted that the invention can be implemented with any metal selected such that, when it is anodized, straight pores that extend orthogonally to the surface exposed to the electrolyte are produced.

It should also be noted that it is possible not to use a hard mask 305, so as to allow a full anodization of the aluminum layer. The vertical electrical connections formed through the remaining aluminum when a mask is used may then be replaced by porous anodic oxide having, in the pores, a conductive material to allow vertical conduction.

Subsequently, and in a manner which is known in itself from prior art document WO 2019/215284, another hard mask 307 is formed above the structure to delimit the vertical pores that are intended to be used subsequently to form a 3D capacitor. Hard mask 307, which is insulating (for example comprising silicon dioxide) therefore comprises a first opening OP1 that delimits an anodic porous oxide region.

Above the structure and inside the pores, a stack of materials is formed in a conformal manner comprising, from bottom to top:
- A bottom capacitor electrode layer 308 (titanium nitride: TiN) comprising a 3D portion 308A inside the pores and two 2D portions 308B_A and 308B_B above the second hard mask, with the portions being electrically connected together as they form single layer,
- A dielectric layer (for example a Oxide-Nitride-Oxide layer (ONO), or aluminum oxide, or hafnium oxide) comprising a 3D portion 309A inside the pores and two 2D portions 309B_A and 309B_B, respectively above the 3D portion of the bottom capacitor electrode layer and the 2D portions of the bottom capacitor electrode layer,
- A top capacitor electrode layer (titanium nitride: TiN) comprising a 3D portion 310A inside the pores and two 2D portion 310B_A and 310B_B, respectively above the 3D portion of the dielectric layer and the 2D portions of the dielectric layer.

These three layers are deposited in a conformal manner, they conform to the shape of the pores, and, where the surface is flat (above the second hard mask for example), they conform to this flatness.

A 3D capacitor 3DC is formed, comprising the 3D portion 308A of the bottom capacitor electrode layer, the 3D portion 309A of the dielectric layer, and the 3D portion 310A of the top capacitor electrode layer. It should be noted that in a 3D capacitor, the surfaces of the functional electrodes (the surfaces that face each other that contribute to the capacitance) extend in three dimensions (horizontally at the bottom of the pores and vertically on the walls of the pores on the figure).

A first 2D capacitor 2DC_A has also been formed, comprising the 2D portion 308B of the bottom capacitor electrode layer, the 2D portion 309B of the dielectric layer, and the 2D portion 310B of the top capacitor electrode layer. It should be noted that in a 2D capacitor, the surfaces of the functional electrodes (the surfaces that face each other that contribute to the capacitance) extend in two dimensions (horizontally on the figure).

A second 2D capacitor 2DC_B has also been formed, comprising the 2D portion 308B_B of the bottom capacitor electrode layer, the 2D portion 309B_B of the dielectric layer, and the 2D portion 310B_B of the top capacitor electrode layer. It should be noted that in a 2D capacitor, the surfaces of the functional electrodes (the surfaces that face each other that contribute to the capacitance) extend in two dimensions (horizontally on the figure).

A conductive layer, including aluminum, is then deposited above the structure. Through a photolithography step, three metal contacts are formed:
3D top metal contact 311A above and in electrical contact with the 3D portion 310A of the top capacitor electrode (it should be noted that this top metal contact may also be absent, for example if the 3D capacitor is a dummy capacitor not meant to be used subsequently, in fact, it is not used when characterizing the bottom electrode layer),
2D top metal contact 311B_A above and in electrical contact with the 2D portion 310B_A of the top capacitor electrode of the first 2D capacitor.
2D top metal contact 311B_B above and in electrical contact with the 2D portion 310B_B of the top capacitor electrode of the second 2D capacitor.

It should be noted that the photolithography step will include an etching of the portions of the top capacitor electrode layer not covered by metal contact 311A or metal contact 311B_A or metal contact 311B_B, and the top capacitor electrodes are at this stage separated.

A second opening OP2 is formed on a side of the anodic porous oxide region opposite to the side including the 2D capacitor, through the two hard masks 305 and 307, and the portions of the dielectric layer and of the bottom capacitor layer. In fact, this opening opens onto a region REG of the metal layer 304.

It should be noted that in all the embodiments of the present disclosure, the second opening is formed on a side of an anodic porous oxide region opposite to the side including a 2D capacitor (or a portion of 2D capacitor, or even a 2D portion of top capacitor electrode).

A metal contact 313 is then formed and patterned in this second opening, with a passivation layer 314 covering it. The material used for the metal contact is also deposited on metal contacts 311A, 311B_A, and 311B_B.

It appears that an electrical contact is formed between metal contact 313 and the two 2D portions of the bottom capacitor electrode layer, through the metal region REG, the tungsten layer 303, and the 3D portion of the bottom capacitor electrode layer. This electrical contact is represented by means of a thick dashed line. Consequently, metal contact 313 is a 2D bottom metal contact as well as a 3D bottom metal contact. It should be noted that the invention is not limited to a metal region REG and may also be implemented with a vertically conductive region comprising anodic porous oxide having, in the pores, conductive material extending from top to bottom.

The bottom capacitor electrode layer 308 extends continuously between the 2D portions of the bottom capacitor electrode layer. On the figure, this portion is referenced RC. Measurements relating to the portion RC and a fortiori relating to the bottom capacitor electrode layer can be made through the 2D portions of the top capacitor electrode layer 311B_A and 311B_B.

In particular, measurements can be made after the dielectric of the 2D capacitors has been damaged, i.e. after a voltage above the breakdown voltage of the 2D capacitors has been applied so as to render conductive the 2D capacitors and their dielectric.

For example, this allows measuring the resistivity of the bottom capacitor electrode layer, as the distance between the two 2D capacitors can be known.

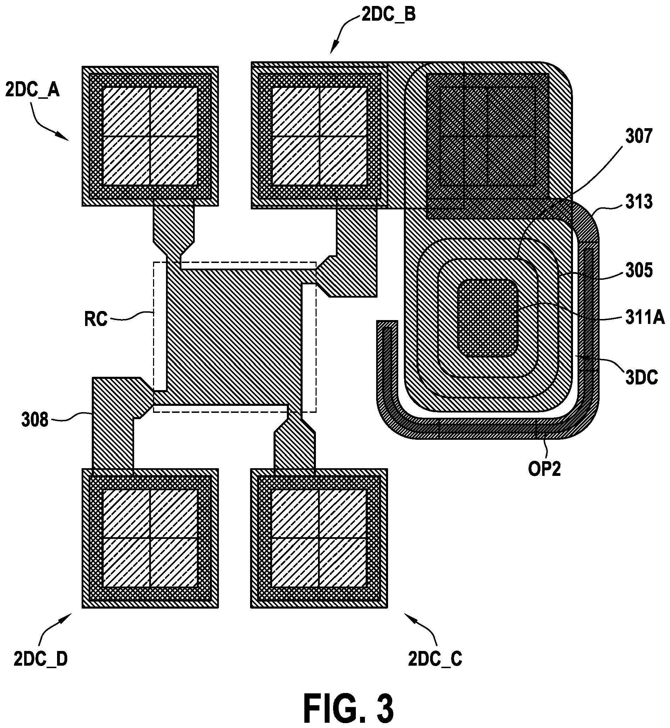

It is also possible to implement more than two 2D capacitors, which allows characterizing the bottom capacitor electrode layer by measuring the sheet resistance of this layer, as will be shown on figure 3.

It should be noted that the bottom capacitor electrode layer 308 has not been patterned on the figure. This layer may also be patterned but must form a direct (by direct, what is meant is that a current can travel through this layer between the elements listed hereinafter) electrical connection between its 2D portions and the 3D portion.

Figure 3 is a top view of a device according to an example. The references of figure 2 are used on this figure to designate the same elements. In particular, the device of this figure comprises four 2D capacitors each having a structure analogous to the ones of the 2D capacitors of figure 2. The four capacitors are referenced 2DC_A, 2DC_B, 2DC_C, and 2DC_D.

As can be observed on the figure, various current paths will be available for the 2D capacitor at the interface between the 2D capacitors and the 3D capacitor 3DC, through the bottom electrode layer 308 which has been patterned in the example of this figure, and through the second opening OP2 described in reference to figure 2. It should be noted that patterning the bottom electrode layer 308 can include etching through this layer and etching through the hard masks underneath it. It should be noted that the second opening OP2 extends around the 3D capacitor to facilitate the flow of current through the bottom electrode layer to reach the bottom contact. This is advantageous as the voltage required to damage the capacitors may be high (for example of the order of 10V).

Preferably, the 2D bottom contact is spaced apart from the 2D capacitors so that the resistances between the 2D capacitors and the bottom contact is greater than the resistance through the portion RC.

Although patterned, it can be observed that there is a direct electrical connection between the bottom capacitor electrodes of all the capacitors of this figure.

Here, the portion RC that will be used to characterize the bottom capacitor electrode layer is in the shape of a square. The four 2D portions of the bottom capacitor electrode layer are each arranged evenly around the square in a Van der Pauw pattern. In particular, they are each connected to a corner of the square.

This configuration will allow performing the Van der Pauw's method to measure the sheet resistance of the bottom capacitor electrode layer, in particular after the 2D capacitors have been damaged.

By way of example, performing the Van der Pauw's method can include applying voltages between the 2D portions of the top electrode layer of the capacitors.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. An electrical device for measuring an electrical parameter of a conductive layer to be characterized, comprising:
a substrate (300),
a conductive anodization barrier (303) above the substrate,
a vertically conductive region (304, REG) above the conductive anodization barrier,
an anodic porous oxide region (306) above the substrate, comprising straight pores extending from a top face of the anodic porous oxide region to the conductive oxidation barrier, the anodic porous oxide region being adjacent to the vertically conductive region,
an insulating region (305, 307) above the vertically conductive region and the anodic porous oxide, having an opening (OP) delimiting a portion of the anodic porous oxide region,
a bottom capacitor electrode layer including a 3D portion (308A) extending inside the pores of the portion anodic porous oxide region through the opening, and at least two 2D portions (308B_A, 308B_B) extending above the insulating region, the bottom capacitor electrode layer extending between the at least two 2D portions of the bottom capacitor electrode layer, the 2D portions and the 3D portion of the bottom capacitor electrode layer being in electrical contact,
a dielectric layer including at least two 2D portions (309B_A, 309B_B) above the at least two 2D portions of the first capacitor electrode layer, and a 3D portion (309A) above the 3D portion of the bottom capacitor electrode layer and inside the pores of the portion of the anodic porous oxide region,
a top capacitor electrode layer including at least two 2D portions (310B_A, 310B_B) above the at least two 2D portions of the dielectric layer, and a 3D portion (310A) above the 3D portion of the dielectric layer and inside the pores of the portion, so that at least two 2D capacitors are formed by the at least two 2D portions of the bottom capacitor electrode layer, the at least two 2D portions of the dielectric layer, and the at least two 2D portions of the top capacitor electrode layer, and so that a 3D capacitor is formed by the 3D portion of the bottom capacitor electrode, the 3D portion of the dielectric layer, and the 3D portion of the top capacitor electrode layer,
the bottom capacitor electrode being said conductive layer to be characterized.

2. The device of claim 1, comprising a bottom capacitor electrode layer including a 3D portion (308A) extending inside the pores of the portion anodic porous oxide region, four 2D portions (308B_A, 308B_B) extending above the insulating region, the bottom capacitor electrode layer extending between the four 2D portions of the bottom capacitor electrode layer, the 2D portions and the 3D portion of the bottom capacitor electrode layer being in electrical contact,
a dielectric layer including four 2D portions (309B_A, 309B_B) above the four 2D portions of the first capacitor electrode layer, and a 3D portion (309A) above the 3D portion of the bottom capacitor electrode layer and inside the pores of the portion of the anodic porous oxide region,
a top capacitor electrode layer including four 2D portions (310B_A, 310B_B) above the four 2D portions of the dielectric layer, and a 3D portion (310A) above the 3D portion of the dielectric layer and inside the pores of the portion, so that four capacitors are formed by the four 2D portions of the bottom capacitor electrode layer, the four 2D portions of the dielectric layer, and the four 2D portions of the top capacitor electrode layer.

3. The device of claim 2, wherein the bottom capacitor electrode layer is continuous in a region containing the four 2D portions of the bottom capacitor electrode layer.

4. The device of claim 2, wherein the bottom capacitor electrode layer is patterned into a given shape, wherein the four 2D portions of the bottom capacitor electrode layer are each arranged evenly around the given shape so as to be arranged in a Van der Pauw pattern, the given shape having two mutually orthogonal axes of symmetry such as a square or a cross or a circle.

5. The device of claim 3, wherein the bottom capacitor electrode layer extends further than the four 2D portions of the bottom capacitor electrode layer.

6. The device of any one of claims 1 to 5, wherein the 2D portions of the dielectric layer are damaged and conducting at the level of each 2D capacitor.

7. The device of any one of claims 1 to 6, wherein a 2D bottom contact is arranged above the vertically conductive region, the 2D bottom contact being in electrical contact with at least one 2D portion of the bottom capacitor electrode layer of a 2D capacitor through the vertically conductive region and the 3D portion of the bottom capacitor electrode layer.

8. A method of manufacturing an electrical device for measuring an electrical parameter of a conductive layer to be characterized, the method comprising:
providing a substrate (300),
forming a conductive anodization barrier (303) above the substrate,
depositing a metal layer above the substrate,
anodizing a region of the metal layer to obtain:
an anodic porous oxide region (306) above the substrate, comprising straight pores extending from a top face of the anodic porous oxide region to the conductive anodization barrier,
a vertically conductive region (304, REG) above the substrate, the anodic porous oxide region being adjacent to the vertically conductive region,
forming a bottom capacitor electrode layer including a 3D portion (308A) extending inside the pores of the portion anodic porous oxide region and at least two 2D portions (308B_A, 308B_B) extending above the insulating region, the bottom capacitor electrode layer extending between the at least two 2D portions of the bottom capacitor electrode layer, the 2D portion and the 3D portion of the bottom capacitor electrode layer being in electrical contact,
forming a dielectric layer including at least two 2D portions (309B_A, 309B_B) above the at least two 2D portions of the first capacitor electrode layer, and a 3D portion (309A) above the 3D portion of the bottom capacitor electrode layer and inside the pores of the portion of the anodic porous oxide region,
forming a top capacitor electrode layer including at least two 2D portions (310B_A, 310B_B) above the at least two 2D portions of the dielectric layer, and a 3D portion (310A) above the 3D portion of the dielectric layer and inside the pores of the portion, so that at least two capacitors are formed by the at least two 2D portions of the bottom capacitor electrode layer, the at least two 2D portions of the dielectric layer, and the at least two 2D portions of the top capacitor electrode layer, and so that a 3D capacitor is formed by the 3D portion of the bottom capacitor electrode, the 3D portion of the dielectric layer, and the 3D portion of the top capacitor electrode layer,
the bottom capacitor electrode being said conductive layer to be characterized.

9. The method of claim 8, comprising applying a voltage between each 2D portion of the top capacitor electrode layer and another point in the device so as to damage the 2D portions of the dielectric layer below each 2D portion of the top capacitor electrode layer so as to make it conducting at the level of each 2D capacitor.

10. A method of characterizing an electrical device, comprising obtaining an electrical device in accordance with any one of claims 1 to 7, and measuring an electrical parameter of the bottom capacitor electrode layer through the 2D portions of the top electrode layer of the at least two 2D capacitors.

11. The method of claim 10, wherein the electrical device is an electrical device in accordance with claim 6, the method comprising measuring the electrical resistivity between two top electrodes of the at least two 2D capacitors.

12. The method of claim 11, wherein the electrical device is an electrical device in accordance with claims 6 and any one of claims 2 to 5, comprising measuring the sheet resistance of the bottom capacitor electrode layer through the four 2D portions of the top capacitor electrode layer.

13. The method of claim 12, wherein the sheet resistance is measured using Van der Pauw's method.
